# EUROPEAN PATENT APPLICATION

(11) **EP 2 757 580 A1**
(43) Date of publication of application: **23.07.2014**
(21) Application number: 13152160.1
(22) Date of filing: 22.01.2013
(51) Int. Cl.: H01L 21/84, H01L 27/12, H01L 21/762

(54) **Bipolar cmos dmos (bcd) processes**

(71) Applicant: NXP B.V., 5656 AG Eindhoven (NL)
(72) Inventor: Boos, Priscilla, Redhill, Surrey RH1 1NY (GB); Van Dalen, Rob, Redhill, Surrey RH1 1NY (GB); Spaan, Erick, Redhill, Surrey RH1 1NY (GB)
(74) Representative: Crawford, Andrew

(57) **Abstract**

There is disclosed a method of manufacturing a high voltage, HV, device with a BCD process. The method comprises undertaking a Local Oxidation of Silicon, LOCOS, fabrication process to form a recessed insulating structure prior to undertaking a Bipolar CMOS DMOS, BCD, fabrication process to form a plurality of device layers on the recessed insulating structure.

## Description

This invention relates to semiconductor processing. More particularly, the invention relates to the Bipolar CMOS DMOS (BCD) processes for manufacturing high power or high voltage products.

Bipolar CMOS DMOS (BCD) process technology incorporates analog components (Bipolar, CMOS, DMOS), digital components (CMOS) and high-voltage transistors (DMOS) on the same die.

A primary driver of BCD process technology growth has been the recent rise of smartphones and tablets. These devices comprise multiple functions which all compete for power: the application processor, baseband processor, the large displays, etc. Such device thus requires one or more Power Management Integrated Circuit (PMIC) chips to manage the power with minimal losses to ensure long battery life.

The other evolving application highly suitable for BCD process Technology is motor-control, which is used in Hard Disk Drives (HDDs) to turn the spindles for example. High-density BCD process technology can be used along with a modern 32-bit microcontroller to implement sophisticated motor-control System-on-Chips (SoCs) that can implement advanced algorithms to help motors deliver the same or greater output, but consume less power.

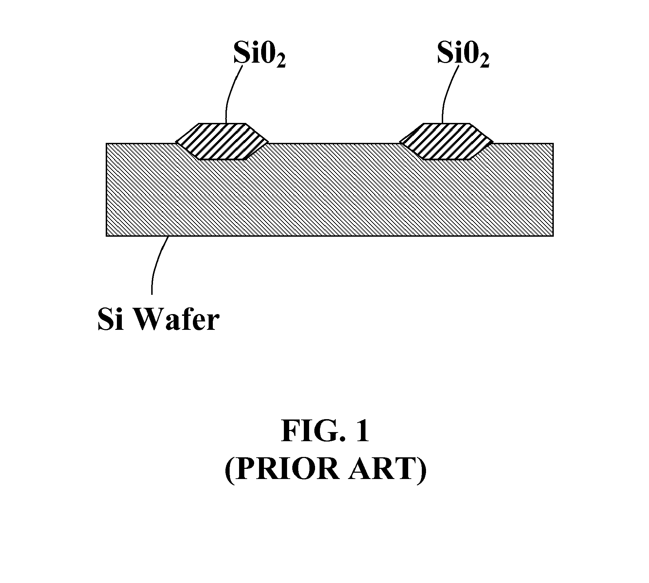

To encounter the demand for much denser CMOS logic, starting from BCD process technology, the Local Oxidation of Silicon (LOCOS) fabrication process has been developed to insulate MOS transistors from each other. LOCOS is a microfabrication process where a silicon dioxide (SiO₂) insulating structure is formed on a silicon (Si) wafer such that the SiO₂ insulating structure penetrates the surface of the wafer causing the Si-SiO₂ interface to occur at a lower point than the rest of the Si wafer surface (as illustrated in Figure 1). For this, thermal oxidation of selected regions is typically used. The oxygen penetrates in the depth of the wafer, reacts with silicon and transforms it in to SiO₂. In this way, a semi-recessed structure is formed.

BCD processes typically employ: a planarized process flow providing for limited topography; low-temperature constraints; and Shallow Trench Isolation (STI) or thin insulating structures (e.g. SIO₂) produced using a LOCOS process.

Conversely, High Voltage (HV) devices typically make use of; thick insulating structures (e.g. SIO₂) produced using a LOCOS process; the Reduced Surface (Resurf) effect; and High-temperature constraints.

Such contradictory conditions make it difficult to include a HV device within a BCD product (e.g. on a die manufactured using a BCD process).

There is proposed a HV device having a tapered insulating structure below a plurality of BCD device layers.

According to an aspect of the invention, there is provided a a HV device according to claim 1.

The tapered isolation structure may be formed using a LOCOS process so as to be recessed in a silicon layer. In such embodiments, the tapered insulating structure may penetrate the surface of the silicon layer so that the tapered insulating structure extends downwardly into the silicon layer so as to have an interface with the silicon layer at a lower point than the rest of the silicon layer upper surface.

Embodiments may provide an advanced BCD device to support HV functionality in the range of 700V. Accordingly, embodiments may be used for applications using large digital and analog content and HV content.

By way of example, LVCMOS/DMOS is typically up to 12V. For other nodes, LV is typically up to 5V CMOS. Medium Voltage (MV), HV, Extra High Voltage (EHV) with conventional LOCOS construction is typically understood to be in the range of 24, 60, 120V, respectively. EHV according to proposed embodiments may be higher than 120V, preferably higher than 500V, more preferably higher than 750V, and even more preferably in excess of 800-900V (as has been demonstrated in tests).

Embodiments may be used for voltages from an estimated 50V up to (and even in excess of) 900V.

Devices made according to an embodiment may be used for applications connected to mains voltage (e.g. 110V, 220V with voltage spikes due to circuit topology/application), for instance notebook adapters, phone adapters or lighting applications (CFL/LED).

According to an aspect of the invention, there is provided a method of manufacturing a HV device according to claim 12.

There is proposed a concept for manufacturing a HV device with a BCD process. Embodiments propose undertaking HV processing steps prior to undertaking Low Voltage (LV) BCD processing steps so as to reduce or minimise any changes to a LV device formed using the BCD processing steps. Embodiments may thus complete processing steps having high-temperature constraints (such as high temperature anneals and the creation of thick insulating structures using a LOCOS process, for example) before undertaking BCD processes.

The insulating structure may be recessed so as to provide a substantially planar surface for trench isolation to be formed using a BCD process. The insulating structure may provide for improved oxide quality and a tapered oxide edge. Such a tapered oxide layer (known as a "birdsbeak") may be beneficial for electrical field distribution and reliability.

The formation of a thick recessed isolation structure (using a LOCOS process for example) together with a buried oxide may enable improved control over the thickness of a thin Silicon-on-Insulator (SOI) layer. Such a thin SOI layer may provide a higher critical electric field compared to a conventional SOI layer created using STI.

Examples of the invention will now be described in detail with reference to the accompanying drawings, in which:
Figure 1 illustrates a semi-recessed insulating structure formed using a LOCOS process;
Figures 2-12 illustrate a process for manufacturing a high-voltage device according to an embodiment of the invention.

The terms, chip, integrated circuit, monolithic device, semiconductor device, and microelectronic device, are often used interchangeably in this field. The present invention is applicable to all the above as they are generally understood in the field.

The terms metal line, interconnect line, trace, wire, conductor, signal path and signalling medium are all related. The related terms listed above, are generally interchangeable, and appear in order from specific to general. In this field, metal lines are sometimes referred to as traces, wires, lines, interconnect or simply metal. Metal lines, generally aluminum (Al), copper (Cu) or an alloy of Al and Cu, are conductors that provide signal paths for coupling or interconnecting, electrical circuitry. Conductors other than metal are available in microelectronic devices. Materials such as doped polysilicon, doped single-crystal silicon (often referred to simply as diffusion, regardless of whether such doping is achieved by thermal diffusion or ion implantation), titanium (Ti), molybdenum (Mo), and refractory metals are examples of other conductors.

The terms contact and via, both refer to structures for electrical connection of conductors at different interconnect levels. These terms are sometimes used in the art to describe both an opening in an insulator in which the structure will be completed, and the completed structure itself. For purposes of this disclosure contact and via refer to the completed structure.

The term vertical, as used herein, means substantially orthogonal to the surface of a substrate. Also, terms describing positioning or location (such as above, below, top, bottom, etc.) are to be construed in conjunction with the orientation of the structures illustrated in the diagrams.

The diagrams are purely schematic and it should therefore be understood that the dimensions of features are not drawn to scale. Accordingly, the illustrated thickness of any of the layers should not be taken as limiting. For example, a first layer drawn as being thicker than a second layer may, in practice, be thinner than the second layer.

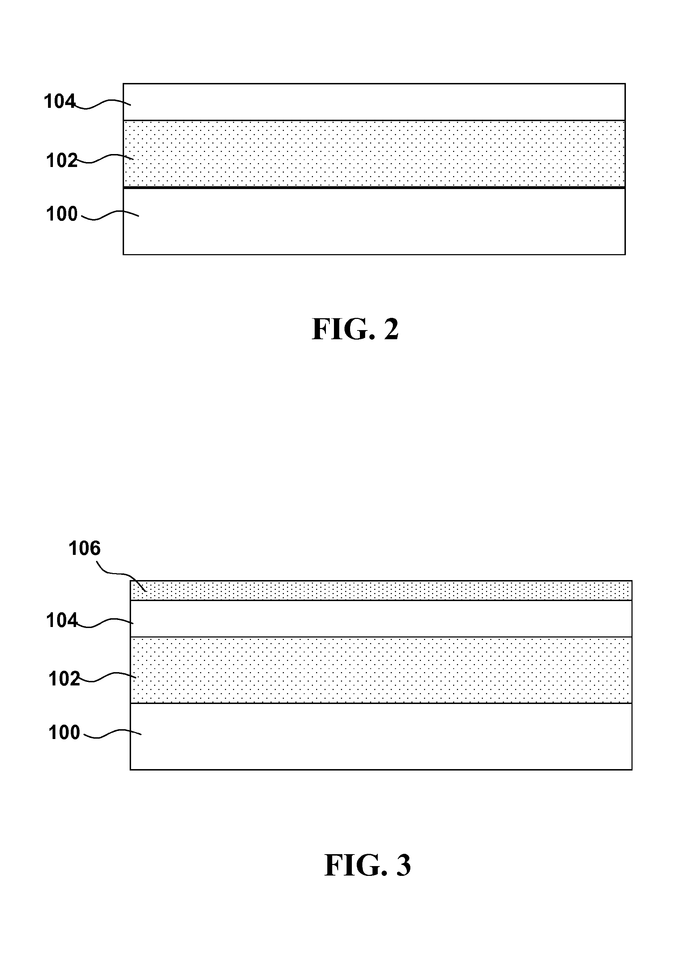

FIG. 2 show a substrate 100, typically comprised of silicon, with an oxide (i.e. insulator) layer 102 formed thereon. Later, this oxide layer 102 will be referred to as a buried oxide layer 102 due to it resultant position in the formed structure. Formed on top of (and covering) the oxide layer 102), there is a silicon (Si) layer 104. Such a Si layer is typically referred to as a Silicon-on-insulator (SOI) layer 104. Here, the thickness of the SOI 104 is in the range of 0.3µm-3µm, depending on the voltage range or starting material for the process node.

Subsequent formation of a (field) oxide layer 106 covering the upper surface of the SOI layer 104 is illustrated in FIG. 3. Here, the thickness of the oxide layer 106 is in the range of 5nm-200nm. Of course, other suitable materials and/or thicknesses may be used, as would be apparent to a person skilled in the art.

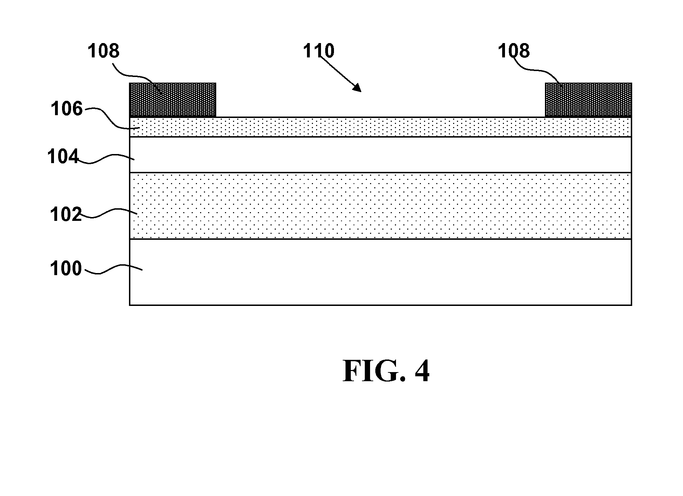

As shown in Figure 4, a silicon nitride layer 108 is formed on the upper surface of the (field) oxide layer 106 and is patterned according to known photolithographic techniques to form exposed area 110. Here, the silicon nitride layer 108 has a thickness in the range of 30nm-200nm Other suitable materials and/or thicknesses may be used for the patterned masking layer 108, as would be apparent to a person skilled in the art.

The silicon nitride layer 108 is also referred to as a patterned masking layer 108. The nitride protects the underlying silicon from oxidizing, while allowing a thermal silicon dioxide SiO₂ layer to grow in the exposed area 110.

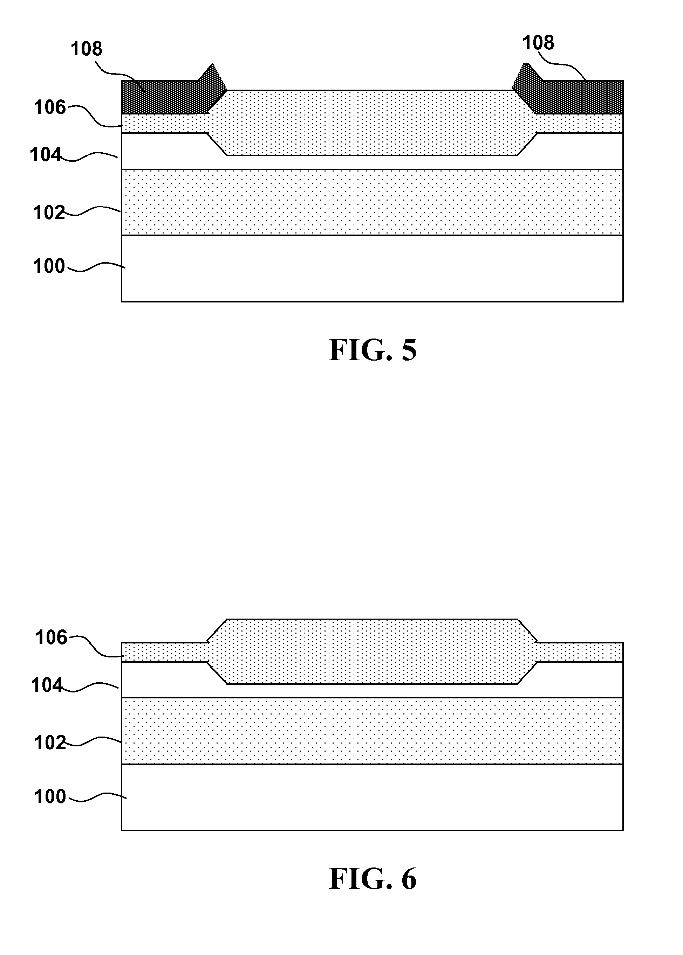

Accordingly, such selective growth of the thick (field) oxide layer 106 on a silicon layer 104 masked by the patterned silicon nitride layer 108 results in partly-recessed (field) oxide layer 106 as shown in Figure 5.

The silicon nitride layer 108 is then removed, resulting is the structure illustrated in FIG. 6.

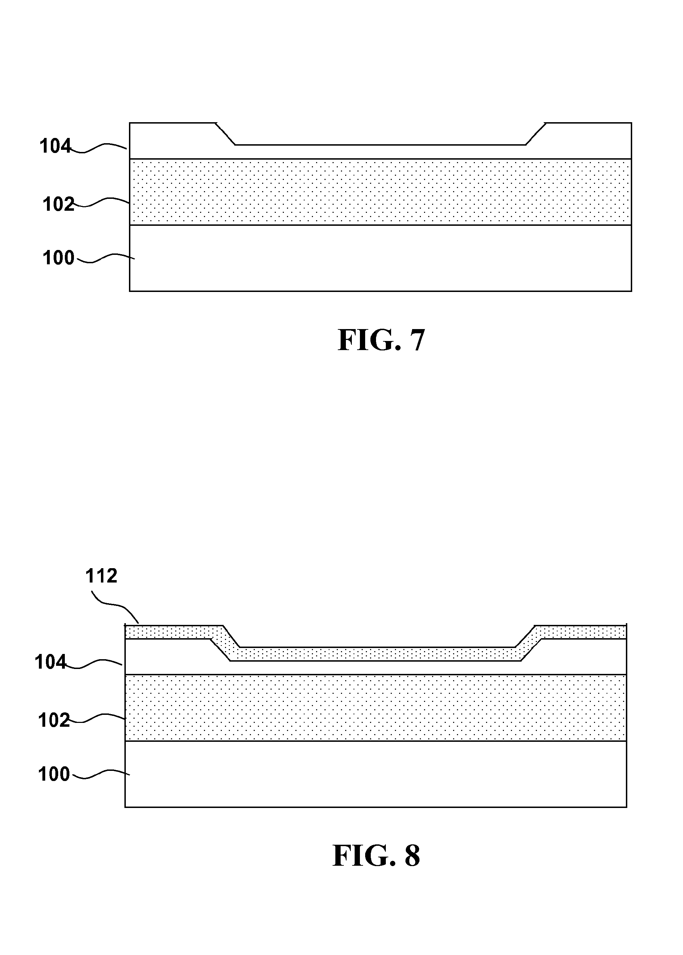

The oxide layer 106 is then also removed, resulting in the structure illustrated in FIG. 7.

Subsequent formation of a (field) oxide layer 112 covering the upper surface of the SOI layer 104 is illustrated in FIG. 8. Here, the thickness of the oxide layer 112 is in the range of 5nm-200nm. Of course, other suitable materials and/or thicknesses may be used, as would be apparent to a person skilled in the art.

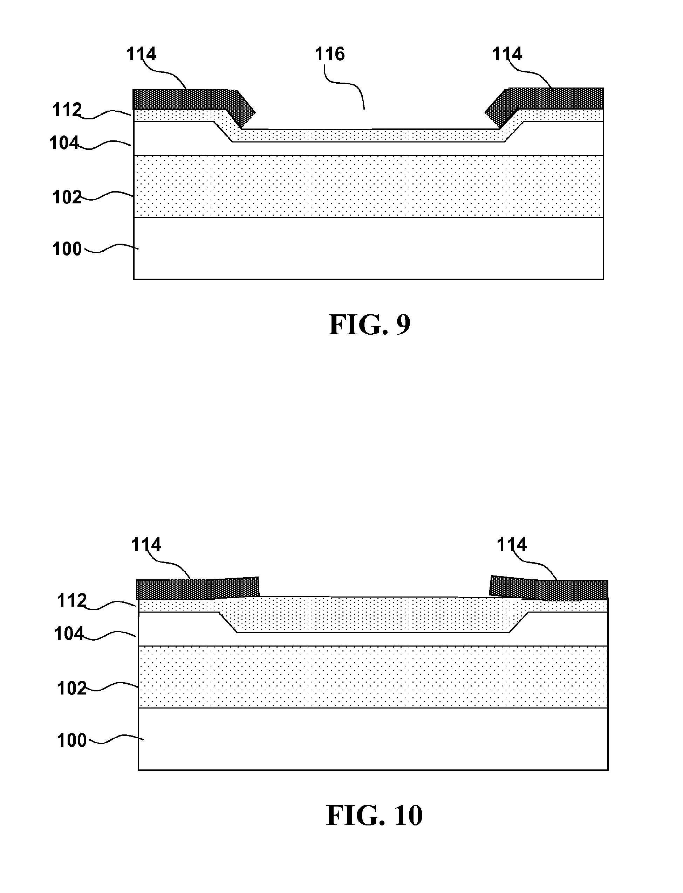

As shown in Figure 9, a masking silicon nitride layer 114 is formed on the upper surface of the (field) oxide layer 110 and is patterned according to known photolithographic techniques to form exposed area 116 above the (field) oxide layer 112. Here, the silicon nitride layer 114 has a thickness in the range of 30nm-200nm. Other suitable materials and/or thicknesses may be used for the patterned masking layer 108, as would be apparent to a person skilled in the art.

The masking silicon nitride layer 114 is referred to as a patterned masking layer 114. The nitride protects the underlying silicon from oxidizing, while allowing a thermal silicon dioxide SiO₂ layer to grow in the exposed area 116. Accordingly, such selective growth of the (field) oxide layer 110 on silicon layer 104 masked by the patterned masking silicon nitride layer 114 results in a recessed (field) oxide layer 106 as shown in Figure 10.

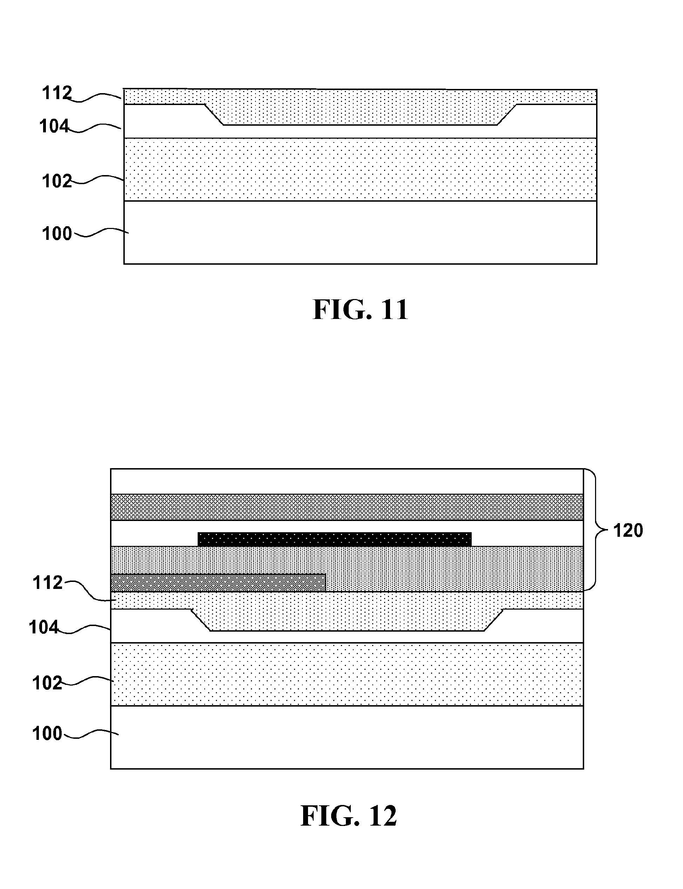

The masking silicon nitride layer 114 is then removed, resulting is the structure illustrated in FIG. 11.

The (field) oxide layer 112 is considered to be (semi) recessed because it extends downwardly into (i.e. penetrates) the surface of the SOI layer 104 causing the Si-SiO₂ (104-112) interface to occur at a lower point than the rest of the SOI layer 104 surface. In other words, the (field) oxide layer 112 is recessed under the starting surface of the SOI layer 104. As result, the thickness of the SOI layer 104 underlying the exposed area 116 (i.e. below the expanded portion of the (field) oxide layer 112 is reduced (by the amount that the oxide layer 112 has expanded downwardly into the SOI layer 104). The resultant thickness of the SOI can be more easily controlled by the selective oxide growth process than a thickness obtained by another method, such as silicon etching for example. As a consequence this resultant thickness of the SOI layer 104 can be less.

The upper surface of the (field) oxide layer 112 has a substantially flat (i.e. planar) top surface as shown in Figure 11.

It will be appreciated that the insulating structure (i.e. the oxide layer 112) formed using LOCOS process steps described above (with reference to Figures 2-11) is nearly fully recessed in the SOI layer 104 such that a large proportion (for example, over 50%) of the entire thickness or vertical extent of the oxide layer 112 is within the SOI layer 104. The resultant insulating structure 112 formed using the LOCOS process steps may provide for improved oxide quality and has what may be referred to as tapered oxide edge, since the thickness of the insulating structure 112 tapers (e.g. increases or decreases) from a first thickness to a second thickness along a horizontal portion of the insulating structure 112. In other words, along a horizontal segment of the insulating structure 112, the thickness of the insulating structure 112 gradually thins or narrows towards the outer edge of the structure. Thus, at a first position, the insulating structure 112 has a first thickness, and, at a second position, the insulating structure 112 has a second different thickness, wherein between the first and second positions the thickness gradually changes from the first thickness to the second thickness in a generally monotonic increasing or decreasing fashion.

Such a tapered oxide layer (also known as a "birdsbeak") may improve electrical field distribution and reliability. Also, the resultant insulating structure 112 has a substantially flat or planar upper surface, thereby enabling trench isolation formation using a BCD process.

Thus, Figure 11 shows a HV extension of a device that has been formed using LOCOS processing steps. BCD process steps can be undertaken after such LOCOS process steps to construct trench isolation and well formations above the insulating structure, as depicted in Figure 12 which shows the formation of a plurality of layers 110 above the oxide layer 106 using BCD process steps.

Accordingly, in an embodiment such as that described above, a HV extension of a 700V MOS transistor is constructed prior to the trench isolation and well formations formed using a BCD process. This may keep any changes to low voltage behaviour to a minimum. The HV extension in a thin film SOI 700V device comprises a gradually doped thin SOI layer, where the thickness and doping profile of the SOI layer are preferably controlled.

In an embodiment, the MOS channel may be the same as for a low voltage device and thus created during the standard BCD process.

Embodiments may help to reduce LV device behaviour changes by placing undertaking HV processing steps in front (i.e. before) LV process steps.

By providing no topography at the start of CMOS processing steps, embodiments may avoid lithography limitations in CMOS that may otherwise be caused by topography,

Embodiments may also provide better oxide quality than for STI-like construction.

Embodiment may exhibit less mechanical stress than for STI-like construction, thus providing less dislocations and improved reliability.

Improved electrical field distribution may be provided in a HV device manufactured according to an embodiment due to the provision of a gradual oxide step (i.e. birdsbeak) instead of STI-like oxide step.

Various modifications will be apparent to those skilled in the art.

For example, the recess formed in the SOI layer 104 using a LOCOS process (as shown in Figure 7) may alternatively be formed using Si etching (either isotropic or anisotropic). However, it has been found that the recessed oxide layer 112 subsequently formed using LOCOS processing with this alternatively formed recess may exhibit reduced/poorer flatness and control of the oxide layer 112 depth may be more difficult.

Alternatively, the recess formed in the SOI layer 104 using a LOCOS process (as shown in Figure 7) may be created by skipping the nitride etch illustrated Figures 5-6, continuing with an oxide etch and then re-using the nitride/oxide stack that remains as the masking for the second oxidation, thereby reducing the number of masks.

## Claims

1. A high voltage, HV, device comprising:
a silicon layer (104);
a tapered insulating structure (112) formed on the silicon layer; and
a plurality of Bipolar CMOS DMOS, BCD, device layers (120) formed above the tapered insulating structure,
wherein the tapered insulating structure is at least partially recessed in the silicon layer.

2. The device of claim 1, wherein the tapered insulating structure (112) penetrates the surface of the silicon layer (104) so that the tapered insulating structure extends downwardly into the silicon layer so as to have an interface with the silicon layer at a lower point than the rest of the silicon layer upper surface.

3. The device of claim 1 or 2, further comprises:
a substrate (100); and
an insulation layer (102) formed above the substrate,
wherein the silicon layer (104) is formed on the insulation layer.

4. The device of any preceding claim, wherein the thickness of the silicon layer (104) is 3µm or less.

5. The device of any preceding claim, wherein the thickness of the tapered insulating structure (112) is in the range of 5nm-200nm.

6. The device of any preceding claim, wherein the silicon layer (104) is gradually doping so as to have a doping profile that varies between its upper surface and lower surface.

7. The device of any preceding claim, wherein the HV device comprises a 50V-900V transistor.

8. The device of any preceding claim, wherein the tapered insulating structure (112) comprises an oxide.

9. The device of any preceding claim, wherein the tapered insulating structure (122) has a substantially planar upper surface.

10. The device of any preceding claim,
wherein, at a first position, the tapered insulating structure (112) has a first thickness, and, at a second position, the tapered insulating structure has a second different thickness,
and wherein between the first and second positions the thickness gradually changes from the first thickness to the second thickness in a monotonic fashion.

11. An electronic circuit comprising a device according to any preceding claim.

12. A method of manufacturing a high voltage, HV, device comprising the steps of:
forming a tapered insulating structure on a silicon layer such that the tapered insulating structure is at least partially recessed in the silicon layer; and
forming a plurality of Bipolar CMOS DMOS, BCD, device layers above the tapered insulating structure.

13. The method of claim 12, wherein forming a tapered insulating structure comprises:
providing a substrate layer (100);
forming an insulation layer (102) on the substrate layer;
forming a Silicon-On-Insulation, SOI, layer (104) on the insulation layer;
and
forming a recessed oxide layer (112) on the SOI layer.

14. The method of claim 13, wherein the step of forming a recessed oxide layer (112) comprises:
forming an oxide layer (112) on the SOI layer (104);
covering one or more areas of the oxide layer with a masking layer (114) to leave one or more exposed areas (116) of the oxide layer; and
using thermal oxidation to grow the one or more exposed areas of the oxide layer.

15. The method of claim 13 or 14, wherein the step of forming a recessed oxide layer (106) further comprises, prior to forming an oxide layer (112) on the SOI layer (104), undertaking the step of:
selectively growing an oxide layer (106) on the SOI layer (104) and then removing the oxide layer to form a recess in the SOI layer (104)
